# EUROPEAN PATENT APPLICATION

(11) **EP 3 796 765 A1**
(43) Date of publication of application: **24.03.2021**
(21) Application number: 19382818.3
(22) Date of filing: 23.09.2019
(51) Int. Cl.: H05K 7/20

(54) **POWER CONVERTING SYSTEM AND BATTERY CHARGER WITH IMPROVED THERMAL DISSIPATION**

(71) Applicant: Wall Box Chargers S.L., 28108 Alcobendas (Madrid) (ES)
(72) Inventor: CASTAÑEDA MAÑÉ, Eduard, 08740 Sant Andreu de la Barca (Barcelona) (ES); ALMEIDA ARAUJO, Jaime Tiago, 08740 Sant Andreu de la Barca (Barcelona) (ES); GIMENO ORTÍ, Martí, 08740 Sant Andreu de la Barca (Barcelona) (ES)
(74) Representative: Gallego Jiménez, José Fernando

(57) **Abstract**

The invention refers to a power converting system (10) comprising a power converter device (12), a housing (14), and a thermally conductive filler (16). The housing encloses the power converter device (12) and the thermally conductive filler (16). The thermally conductive filler (16) surrounds the power converter device (12) and fills at least in part a space between the power converter device (12) and at least a part of an internal surface of the housing (14). The invention further refers to a battery charger comprising such a power converting system.

## Description

### FIELD OF THE INVENTION

The present invention is in the field of battery chargers. In particular, the invention relates to a battery charger with improved dissipation of internally generated heat.

### BACKGROUND OF THE INVENTION

Electric power battery technologies have undergone very rapid progress in recent years. Significant improvements in the energy storage and energy supply capacities as well as in charge efficiency of batteries have been achieved along with continuously increasing cost efficiency. As a consequence, batteries are becoming ubiquitous in many industries, in particular transportation. The advent of the electric car is a prominent example.

Together with the evolution of battery technology, battery chargers are evolving along. Broad use of power batteries requires a correspondingly broad infrastructure of battery chargers. Battery chargers need to satisfy increasingly demanding requirements regarding size reduction, energy efficiency, manufacturability and cost efficiency.

Thermal dissipation is a major issue in battery chargers. The internal electronic components and circuitry of a battery charger, in particular power converters, generate large amounts of heat that need to be dissipated to an exterior of the battery charger in order to avoid overheating. A possibility exploited in traditional battery chargers is the use of forced cooling, for example by means of ventilators creating air currents within the battery charger. However, the use of such means for forced cooling causes increased maintenance costs and reduced maintenance time intervals.

Thus, there is room for technical improvement regarding battery chargers.

### SUMMARY OF THE INVENTION

The present invention addresses the problem of providing means for charging a battery, in particular a power converting system for a battery charger, which provide good thermal dissipation properties and reduced maintenance costs without compromising manufacturability and energetic efficiency. This problem is solved by a power converting system according to claim 1 and by a battery charger according to claim 15. Preferred embodiments of the invention are defined in the appended dependent claims.

A first aspect of the invention refers to a power converting system. The power converting system comprises a power converter device. "Power converter device" refers herein to a device configured for converting electrical energy from an energy supply, in particular a power supply, into electrical energy to a load, for example into an electrical voltage or current having suitable frequency and/or amplitude for providing the load with electrical energy. The load may be an electric battery or any electric device in general requiring a supply of electric energy. In preferred embodiments of the invention, the power converter device may in particular be an AC to AC converter. The power converter device may comprise a transformer comprising a first coil inductively coupled with a second coil and a magnetic core guiding lines of magnetic flux through the first coil and through the second coil. The power converter device may however comprise further and/or other components.

The power converting system further comprises a housing. The housing may be configured for receiving and enclosing in the interior thereof the remaining components of the power converting system, such that one or more surfaces of the housing may define one or more external surfaces of the power converting system. The housing may be a box-like housing comprising a bottom plate, a top plate and at least one lateral housing wall extending between the bottom plate and the top plate, in particular from the bottom plate to the top plate. The bottom plate, the top plate and the at least one lateral housing wall may be substantially planar and define any geometrical shape suitable for satisfying the usability, energy efficiency and design requirements of the power converting system. The at least one lateral wall may be substantially parallel to each other and may be perpendicular to the top plate and to the bottom plate. The bottom plate may be substantially parallel to the top plate.

The housing may for example be a cylindrical housing comprising a circular bottom plate, a circular top plate, and one lateral housing wall extending therebetween. In other examples, the housing may have a parallelepiped shape, in particular a rectangular cuboid shape and comprise a square or rectangular bottom plate, a correspondingly square or rectangular top plate and four square or rectangular lateral housing walls extending between the bottom plate and the top plate.

The power converting system further comprises a thermally conductive filler that surrounds the power converter device and fills at least in part a space between the power converter device and at least a part of an internal surface of the housing. "Internal surface" refers herein to a surface of the housing facing the interior of the housing. The power converter device and the thermally conductive filler are arranged within the housing and are hence surrounded by the internal surface of the housing. The internal surface of the housing may comprise internal surfaces of the bottom plate, of the top plate and of the at least one lateral housing wall.

"Thermally conductive" may generally refer herein to any material having a thermal conductivity greater than the thermal conductivity of air, which is known to be ca. 0,024 W·m⁻¹·K⁻¹. In preferred embodiments of the invention, the thermally conductive filler may comprise a material having a thermal conductivity greater than 0,5 W·m⁻¹·K⁻¹, more preferably greater than 1 W·m⁻¹·K⁻¹. ¹·K⁻¹.

The thermally conductive filler may extend between the power converter device and the entire internal surface of the housing or a part thereof, partly or totally surrounding the power converter device, such as to guide heat produced by the power converter device during operation from the power converter device to the housing, such that it can be rapidly and efficiently dissipated away from the power converting system, in particular through the housing. The thermally conductive filler may or not be in direct contact with the internal surface of the housing and with the power converter device. Preferably, the thermally conductive filler may be in direct contact with the power converter device and with the internal surface of the housing, thereby providing a continuous path of thermally conductive material between the power converter device and the housing through the filler for rapid and efficient thermal dissipation.

The power converter device may be supported by the thermally conductive filler, in particular such that a position and/or orientation of the power converter device is fixed by the thermally conductive filler. For example, the power converter device may be attached to the internal surface of the housing by the thermally conductive filler.

The power converting system of the invention hence provides improved thermal dissipation of heat generated by the power converter device inside the housing during operation of the power converting system. The heat produced by the power converter device is not just thermally radiated through air separating the power converter device from the housing, but instead thermally conducted through the thermally conductive filler. As compared to power converting systems known from the prior art, in which a space between a power converter device and an internal surface of a housing is mostly filled with air, the power converting system of the invention allows achieving improved thermal dissipation ensuring correct working conditions of the power converting system, and in particular avoiding overheating of the power converter device, in particular without necessarily requiring forced ventilation by means of ventilators or the like. Thereby, the maintenance costs of the power converting system can be significantly reduced. The presence of the filler further results in more spatially concentrated and efficient heat dissipation, which prevents the heat generated by the power converter device from reaching other components of the power converting system that may be arranged within the housing, such as passive electronic components, active electronic components and the like.

According to preferred embodiments of the invention, the thermally conductive filler may enclose the power converter device. This may imply that a solid angle defined from the power converter device towards the internal surface of the housing may be mostly covered by the thermally conductive filler. In preferred embodiments of the invention, the thermally conductive filler may completely enclose the power converter device, such that the power converter device may be surrounded by the thermally conductive filler in all directions. It is however possible that the thermally conductive filler encloses one or more sides of the power converter device and exposes or does not cover one or more other sides of the power converter device. For example, the power converter device may be directly attached to the internal surface of the housing and a thermally conductive filler may enclose those sides of the power converter device that do not directly face the internal surface of the housing. By enclosing the power converter device, the thermally conductive filler ensures that a at least a main part of the heat generated by the power converter device during operation can be rapidly and efficiently dissipated away through the thermally conductive filler.

According to preferred embodiments of the invention, the thermally conductive filler may comprise a resin, for example a polyurethane resin, an epoxy resin, a thermosetting plastic, a silicone rubber gel or a combination thereof. The thermally conductive filler may be in the form of a foam, a gel, or a solidifiable liquid, for example solidifiable by drying or curing.

In preferred embodiments of the invention, the housing may comprise a first internal compartment. The first internal compartment may define an internal subvolume of the interior of the housing separated from a remaining of the interior of the housing, such that the interior of the housing is divided in the first internal compartment and the aforesaid remaining of the interior of the housing. The power converter device and the thermally conductive filler may be received within the first internal compartment and the thermally conductive filler may fill at least in part a space between the power converter device and an internal surface of the first internal compartment. This way, the volume to be filled by the thermally conductive filler may be reduced and concentrated in a near environment of the power converter device, in particular in the subvolume of the housing defined by the first internal compartment, thereby achieving an improved material and manufacturing efficiency. In preferred embodiments, the thermally conductive filler may completely fill a space between the power converter device and the internal surface of the first internal compartment and may or not be in direct contact with the power converter device and the internal surface of the first internal compartment of the housing.

In preferred embodiments of the invention, the first internal compartment may be limited by one or more lateral compartment walls and a part of the internal surface of the housing. The one or more lateral compartment walls may extend between the top plate and the bottom plate of the housing, such that the first internal compartment may be defined as a subvolume of the interior of the housing delimited by the one or more lateral compartment walls and subregions of the top plate and bottom plate of the housing respectively defined by corresponding ends of the one or more lateral compartment walls respectively adjacent to the top plate and the bottom plate. The one or more lateral compartment walls may be substantially parallel to each other and to the lateral housing walls and may further be substantially perpendicular to the bottom plate and the top plate.

The first internal compartment may have a shape corresponding to the shape of the housing or a different shape. For example, the first internal compartment may be a cylindrical compartment delimited by one circular - as seen in a top view from the top plate towards the bottom plate or vice versa - lateral compartment wall extending between a circular subregion of the top plate of the housing and a correspondingly circular subregion of the bottom plate of the housing. In other examples, the first internal compartment may be a parallelepiped, in particular a rectangular cuboid delimited by a rectangular or square subregion of the top plate of the housing, a correspondingly square or rectangular subregion of the bottom plate of the housing and four lateral compartment walls extending therebetween. These configurations allow reducing the material and manufacturing requirements for forming the first internal compartment in the housing.

In preferred embodiments of the invention, a part of an internal surface of the first internal compartment may coincide with a part of an internal surface of the housing. In other words, an internal surface of the housing may, in a part thereof, also be an internal surface of the first internal compartment. For example, if the housing has a rectangular cuboid form and the first internal compartment also has a rectangular cuboid form, the first internal compartment may be formed at a corner region of the housing, such that two lateral walls of the housing or subregions thereof form two lateral walls of the first internal compartment. The corresponding subregions of the top plate and the bottom plate of the housing may also form and be part of the internal surface of the housing. This configuration reduces manufacturing and material requirements and further provides shorter thermal transmission paths from the power converter device to an exterior of the housing, thereby improving heat dissipation efficiency.

The power converter device may be supported by the thermally conductive filler, in particular such that a position and/or orientation of the power converter device is fixed by the thermally conductive filler. For example, the power converter device may be attached to the internal surface of the first internal compartment by the thermally conductive filler.

According to preferred embodiments of the invention, the bottom plate and/or the top plate of the housing may be removably attachable to the rest of the housing. For example, the bottom plate or the top plate of the housing may be removably attachable to the at least one lateral housing wall by means of releasable attaching means such as screws or the like. In other examples, the removable bottom plate or top plate may be dimensioned such as to be removably attachable to the rest of the housing, in particular to the at least one lateral housing wall forming a pressure snap connection. The removably attachable top plate or bottom plate may hence act as a removable cover of the power converting system allowing easy access to an interior of the housing, for example for maintenance purposes such as the test or replacement of internal components of the system. Further, having a removably attachable top plate and/or a removably attachable bottom plate increases manufacturing flexibility, inasmuch as it allows access to the interior of the housing up until a stage of fabrication, at which no further access to the interior of the housing is necessary and the removably attachable top plate and/or a removably attachable bottom plate can be used to close the housing.

The cover, i.e. the removably attachable bottom plate or top plate of the housing, may be configured to seal the housing when it is attached to the rest of the housing, such as to protect an interior of the housing from the action of external agents such as dust and humidity. For this purpose, the removably attachable bottom plate or top plate and the at least one lateral housing wall may comprise a sealing element extending around a perimeter thereof, such as a sealing rubber band.

According to preferred embodiments of the invention, the housing may be monolithic. In other preferred embodiments, the housing may comprise a monolithic part of the housing, i.e. the housing may be partly monolithic. wherein the monolithic part of the housing may comprise at least the bottom plate or the top plate and the one or more lateral housing walls For example, in embodiments in which the top plate is removably attachable to the rest of the housing and functions as a cover of the housing, the monolithic part of the housing may comprise the at least one lateral housing wall and the bottom plate of the housing. In other words, the bottom plate and the at least one lateral housing wall may be monolithic with respect to each other, i.e. materially connected to each other. This may reduce manufacturing complexity costs, inasmuch as the monolithic part of the housing may be formed in a single manufacturing process, for example in a moulding process.

In preferred embodiments of the invention, the power converting system may further comprise heat dissipation fins arranged on an outer surface of the housing. "Outer surface" refers herein to a surface of the housing facing the exterior thereof. In embodiments in which the housing is at least partly monolithic, the monolithic part of the housing may further comprise the dissipation fins, such that that the dissipation fins can be formed in the same single manufacturing process, for example a moulding process, as the other components of the monolithic part of the housing. For example, in embodiments in which the top plate is removably attachable to the rest of the housing and functions as a cover of the housing, the at least one lateral housing wall, the bottom plate of the housing and dissipation fins arranged on the external surface of the bottom plate of the housing may be monolithic with respect to each other, i.e. materially connected to each other. This may further contribute to reducing manufacturing complexity and costs. For example, a dedicated manufacturing process for forming the dissipation fins, such as a mechanical machining of the thermal dissipation fins or an attaching of independent thermal dissipation fins to the housing, can be omitted. The fact that the thermal dissipation fins be monolithic with the housing or a part thereof further increases the efficiency of thermal dissipation through the fins.

In preferred embodiments of the invention, the housing may be of a thermally conductive material preferably a metal or an alloy. The housing may for example comprise or be formed of aluminium or an alloy thereof. However, the use of other thermally conductive materials, both metallic and non-metallic, such as copper or alloys thereof or carbon fiber, is also possible. The material of the housing may further be an electrically conductive material, for example in the case of a metal, such that the housing may form a Faraday cage enclosing the internal components of the housing, in particular the power converter device. Thus, the housing may be suitably configured for providing thermal dissipation of heat generated during operation in an interior of the housing and further be configured for providing electromagnetic isolation of the interior of the housing from an exterior of the housing.

In preferred embodiments of the invention, the power converter device may be configured for operating in the high frequency range, preferably in the range of 100 kHz to 2 MHz, more preferably in the range from 250 kHz to 500 kHz or from 250 kHz to 750 kHz. The inventors of the present invention found out that a power converting systems according to the embodiments described herein may be particularly suitable for operating in high frequency ranges, in particular in the range from 250 kHz to 750 kHz, while still providing sufficient thermal dissipation for the power converting system to operate in acceptable conditions. Operating in such high frequency ranges allows decreasing the size of the power converter device, for example of the capacitors thereof, and hence contributes to obtaining a power converting system with a reduced size and less heat production.

The power converting system may further comprise electronic components, such as MOSFETs or IGBT transistors, arranged on an internal surface of the housing. "Electronic components" as used henceforth may refer to electronic components other than the power converter device.

The electronic components may be arranged on an internal surface of the housing, for example on an internal surface of a bottom plate or a top plate of the housing. Thereby, dissipation of the heat generated in the interior of the housing by the electronic components can be rapidly and efficiently guided to an exterior of the housing. The electronic components, in particular the MOSFETs or IGBT transistors, may be arranged outside of the first internal compartment of the housing in which the power converter device is arranged. The electronic components, in particular the MOSFETs IGBT transistors, may be electrically connected to the power transformer device and configured to rectify an AC electric current provided by the power transformer device such as to transform it into a DC electric current, such that the power transforming system can operate as an AC-DC converter with the power transformer device operating as an AC-AC converter.

Preferably, the power converting system may further comprise a dielectric element directly arranged on the internal surface of the housing and the electronic components may be arranged on the dielectric element. The dielectric element may be interposed between the electronic components and the interior surface of the housing. The dielectric element may be in the form of a dielectric sheet of dielectric material. For example, a dielectric sheet may be directly arranged, for instance attached, to the bottom plate of the housing and a plurality of the aforementioned MOSFETs or IGBT transistors may be directly arranged on the dielectric sheet, for instance attached thereto. In some embodiments, the electronic components may be attached to the internal surface of the housing by means of the dielectric element. The dielectric element may comprise an elastomer, for example silicone or mica. In some embodiments, the dielectric element may be of a thermally conductive dielectric material. The dielectric element may hence provide electromagnetic insulation of the electronic components from an exterior of the housing and may further improve thermal dissipation of heat produced by the electronic components in the housing, in particular the electronic components arranged on the dielectric element.

The power converting system may further comprise a board base, for example a PCB. The board base may comprise circuitry elements for electronically implementing the functionalities of the power converting system when interacting with external devices, such as a battery to be charged, in particular for implementing the functionalities of a battery charger, for example connectivity to other devices, in particular an external battery to be charged, and charging parameters such as electric current, electric voltage or electric power. Preferably, the board base may be arranged on the electronic components, for example on MOSFETs.

According to preferred embodiments of the invention, the housing may comprise a second internal compartment. The second internal compartment may be similar in construction to the first internal compartment. In some embodiments, the second internal compartment may be adjacent to the first internal compartment. The second internal compartment may be larger than the first internal compartment. The electronic components, for example MOSFETs, may be arranged in the second internal compartment. Thus, a subvolume of the interior of the housing containing the electronic components, i.e. the interior of the second internal compartment, may be separated from a subvolume of the interior of the housing containing the power converter device, i.e. the first internal compartment, for example by one or more lateral compartment walls of the first internal compartment and/or of the second internal compartment. The lateral compartment walls of the second internal compartment and the lateral compartment walls of the first internal compartment may overlap with each other at least in part, for example in embodiments in which the first internal compartment and the second internal compartment are adjacent to each other, wherein "overlap" refers herein to a lateral compartment wall being at the same time a lateral compartment wall of the first internal compartment and a lateral compartment wall of the second internal compartment, at least for a part of said lateral compartment wall. Having the electronic components arranged in a different compartment as the power converter device may allow for a better thermal and/or electromagnetic isolation between the electronic components and the power converter device.

In preferred embodiments of the invention, at least a portion of an internal surface of the housing may be polished, for example as a result of a mechanical or chemical polishing process. Preferably, electronic components other than the power converter device, for example MOSFETs, may be arranged over said at least one polished portion of the internal surface of the housing. As a result of the polishing process, the polished portion of the internal surface of the housing has a regular and planar internal profile that favours thermal dissipation as compared to a rough non-polished-surface. Thus, these configurations contribute to better thermal dissipation of the heat generated in the interior of the housing by the electronic components.

In preferred embodiments of the invention, the housing may further comprise at least two resealable openings that are respectively arranged on opposed surfaces of the housing. At least a first resealable opening may for example be arranged on the top plate of the housing while at least a second resealable opening may be arranged on the bottom plate of the housing. Other equivalent configurations are possible. Preferably, the at least two resealable openings are arranged such that one of the two resealable openings is closer to the earth, i.e. to the floor, as the other resealable opening, taking into account an orientation of the housing during operation. The resealable openings may comprise a resealing mechanism such as a pressure valve, a movable membrane or the like allowing them to react to a gradient of pressures in the interior of the housing, which may result from heat production leading to warm air concentrating in an upper part of the interior of the housing, by opening, thereby enabling a flow of air from an exterior of the housing through the interior of the housing. The at least two resealable openings may be arranged on a part of the surface of the housing corresponding to the second internal compartment. The at least two resealable openings may extend through a thickness of the lateral housing walls, the bottom plate and/or the top plate of the housing.

In preferred embodiments of the invention, the housing may further comprise a third internal compartment filled with a fluid, preferably a gas, more preferably air. The third internal compartment may be similar in construction to the first and/or second internal compartment and may be adjacent to the first and/or second internal compartment. The third internal compartment, being filled with a fluid having a given heat absorption capacity, may allow improving thermal isolation between parts of the housing, in particular between internal compartments separated by the third internal compartment.

In some embodiments, the power converting system may comprise a fourth internal compartment. The fourth internal compartment may comprise further electronic components, in particular one or more auxiliary coils. An auxiliary coil may for example operate as a power factor correction coil of the power correcting system. The aforesaid third internal compartment may be arranged between the fourth internal compartment and the first internal compartment, such that the first internal compartment, which may contain the coils of the power converter device, and the fourth internal compartment, which contains the one or more auxiliary coil, are separated from each other by the third internal compartment, whereby an improved thermal isolation between the interior of the first internal compartment and the interior of the fourth internal compartment can be achieved, in particular as compared to a situation in which the first internal compartment is adjacent to the fourth internal compartment. The first, third and fourth internal compartments may be adjacent to the second internal compartment, which may contain one or more MOSFETs. This configuration of the power converting system has been found by the inventors to prove particularly efficient for distributing the different components of the system in compartments, in terms of manufacturing and material efficiency, spatial efficiency, and thermal dissipation efficiency..

A further aspect of the invention refers to a battery charger for charging power batteries comprising a power converting system according to any of the embodiments described hereinabove. The power converting system may in particular operate as an AC-DC converter. The battery charger may, for example, be a battery charger for charging the power batteries of electric car. Thanks to the improved thermal dissipation of the power converting system and the higher frequency range at which the power converter device may operate according to the present invention, the battery charger allows omitting means for forced cooling, such as ventilators, without compromising the ability of the battery charger to dissipate heat generated by the internal components thereof.

### BRIEF DESCRIPTION OF THE FIGURES

Fig. 1 schematically illustrates a power converting system according to embodiments of the invention, wherein figs. 1a, 1b and 1c illustrate different views.
Fig. 2 schematically illustrates a power converting system according to embodiments of the invention, wherein figs. 2a and 2b illustrate different views.
Fig. 3 schematically illustrates a housing of a power converting system according to embodiments of the invention, wherein figs. 3a to 3d illustrates different views.
Fig. 4 schematically illustrates a power converting system according to embodiments of the invention, wherein figs. 4a to 4c illustrates different views.
Fig. 5 schematically illustrates a battery charger according to embodiments of the invention.

### DESCRIPTION OF PREFERRED EMBODIMENTS OF THE INVENTION

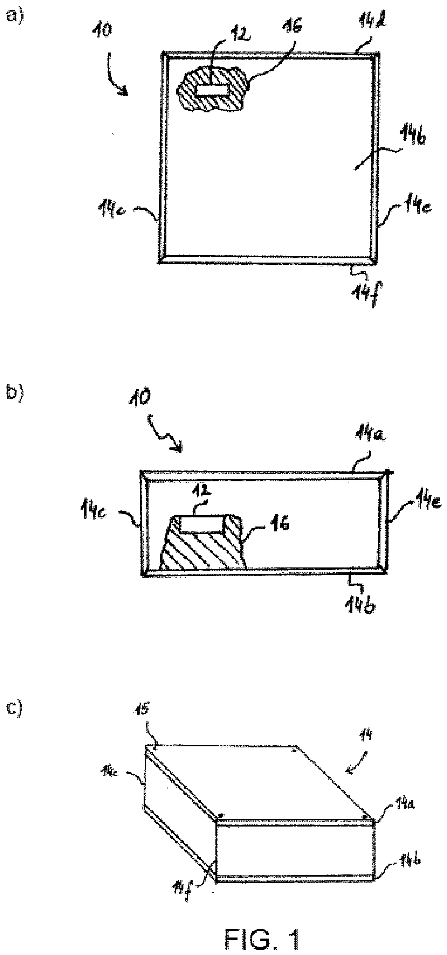

Fig. 1 illustrates a power converting system 10 according to an embodiment of the invention. Fig. 1 a illustrates a top view of the power converting system 10, while Fig. 1b illustrates a side cross-sectional view of the power converting system 10. The power converting system 10 comprises a power converter device 12, which in the embodiment shown is an AC-AC power converter configured to operate at a frequency of 450 kHz.

The power converter device 12 is surrounded by a thermally conductive filler 16 made of polyurethane resin. In the embodiment shown, the thermally conductive filler 16 completely surrounds the power converter device 12 in the plane shown in Fig. 1a and, as seen in Fig. 1b, encloses all sides of the power converter device 12, which in the embodiment shown has a rectangular cuboid form, with the exception of the top side of the power converter device 12, which remains exposed by the thermally conductive filler 16 and can be used for coupling or connecting the power converter device 12 to further devices, for example by means of wired electrical connections.

The power converter device 12 is supported by the thermally conductive filler 16 and is attached to the internal surface of the housing 15 by the thermally conductive filler 16, such that the position of the power converter device 12 is fixed by the thermally conductive filler 16.

The power converting system 10 further comprises an aluminium housing 14 that encloses the power converter device 12 and the thermally conductive filler 16, such that the power converter device 12 and the thermally conductive filler 16 are received in the interior of the housing 14. In the embodiment shown, the housing 14 has a box-like rectangular cuboid shape.

Fig. 1c illustrates a perspective view of the housing 14 from an exterior of the power converting system 10. The housing 14 comprises a rectangular top plate 14a, a rectangular bottom plate 14b and four lateral housing walls 14c-14f, which extend from the bottom plate 14b to the top plate 14a. The top plate 14a is removably attachable to the four housing walls 14c-14f, such as to close and open the housing 14. Since the housing 14 is of aluminium, when the housing is closed by the removable top plate 14a, the housing 14 forms a Faraday cage that encloses the power converter device 12 and a thermally conductive filler 16. In the embodiment shown, the top plate 14a is removably attached to the housing walls 14c-14f by means of screws 15.

As seen in Fig. 1b, the thermally conductive filler partly fills a space between the power converter device 12 and a part of an internal surface of the bottom plate 14b. The thermally conductive filler 16 is in direct contact with the power converter device 12 and with said part of the internal surface of the bottom plate 14b.

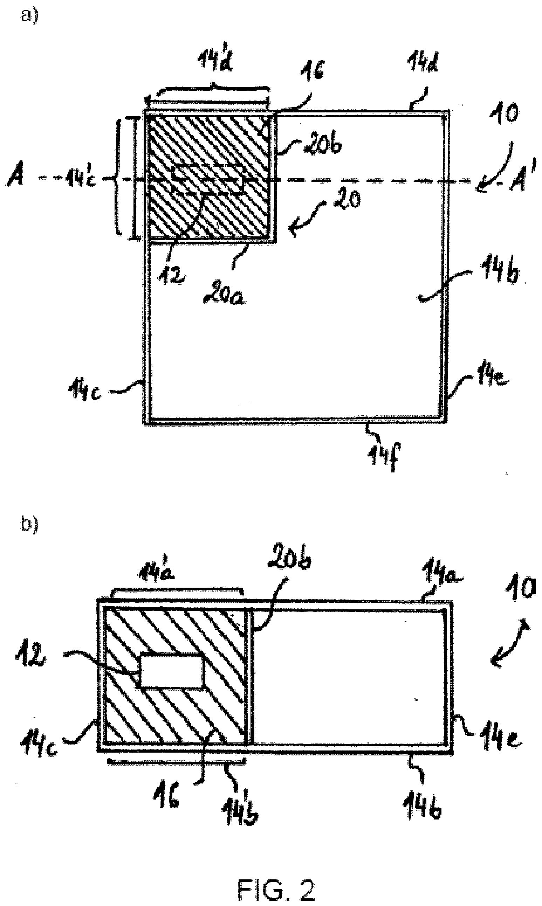

Fig. 2 illustrates a power converting system 10 according to a related embodiment of the invention that comprises all components described for the embodiment illustrated in Fig. 1, for which the same reference numerals are used. A new detailed description of these components is omitted for brevity.

In the power converting system 10 illustrated in Fig. 2, the housing 14 comprises a first internal compartment 20, which is separated from a remaining part of the interior of the housing 14 by a first lateral compartment wall 20a and a second lateral compartment wall 20b. Fig. 2a illustrates a top view of the power converting system 10, in which the top plate 14a is omitted for illustrative purposes. The first and second lateral compartment walls 20a and 20b are mutually perpendicular. The first lateral compartment wall 20a is arranged between the second and fourth lateral housing walls 14d and 14f parallel thereto and perpendicular to the first lateral housing wall 14c. The first lateral compartment wall 20a extends from the first lateral housing wall 14c for a length smaller than a length of the second and fourth lateral housing walls 14d and 14f. Likewise, the second lateral compartment wall 20b is arranged between the first lateral housing wall 14c and the third lateral housing wall 14b and extends, from the second lateral housing wall 14d, perpendicular thereto and parallel to the first and third lateral housing walls 14c and 14e for a length smaller than a length of the 1st and 3rd lateral housing walls 14c and 14c.

Fig. 2b illustrates a cross-sectional side view of the power converting system 10 illustrated in Fig. 2a corresponding to a cutting plane A-A' that is indicated in Fig. 2a with a dashed line. The first internal compartment 20 is delimited by the first and second lateral compartment walls 20a and 20b, by a part 14c' of the first lateral housing wall 14c extending between the first lateral compartment wall 20a and the second lateral housing wall 14d, and by a part 14d' of the second lateral housing wall 14d extending between the first lateral housing wall 14c and the second lateral compartment wall 20b. As seen in Fig. 2, the first internal compartment 20 is hence limited by the first and second lateral compartment walls 20a and 20b and by a part of the internal surface of the housing 14 corresponding to the internal surface of the aforesaid parts of 14c' and 14d' of the first and second lateral housing walls 14c and 14d.

In the embodiment shown in Fig. 2, the power converter device 12 is received within the first internal compartment 20 and the thermally conductive filler 16 encloses the power converter device 12 completely, on all sides of the power converter device 12, and completely fills a space between the power converter device 12 and the internal surface of the first internal compartment 20.

The internal surface of the first internal compartment 20 is formed by the internal surface of the first and second lateral compartment walls 20a and 20b and by the internal surface of the aforementioned parts 14c' and 14d' of the first and second lateral housing walls 14c and 14d. The aforesaid parts 14c' and 14d of the first and second lateral housing walls 14c and 14d form part of the internal surface of the first internal compartment 20 and also form part of the internal surface of the housing 14. Thus, at the aforesaid parts 14c' and 14d', the internal surface of the first internal compartment 20 coincides with the internal surface of the housing 14.

The same applies, as illustrated in Fig. 2b, to a part 14a' of the top plate 14a of the housing extending between the first lateral housing wall 14c and the second lateral compartment wall 20b and to a corresponding part 14b' of the bottom plate 14b. As seen in Fig. 2b, the second lateral compartment wall 20b extends from the bottom plate 14b to the top plate 14a. The same applies to the first lateral compartment wall 20a.

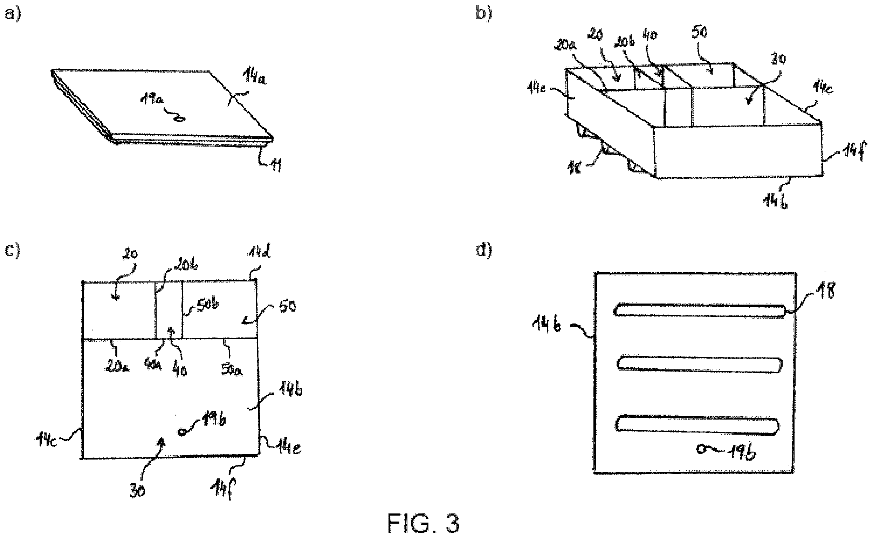

Fig. 3 illustrates a housing 14 of a power converting system 10 according to embodiments of the present invention, wherein only the housing 14 is shown, for illustrative purposes, whereas the remaining components of the power converting system 10, in particular the power converter device 12 and the thermally conductive filler 16 are not shown in Fig. 3.

Fig. 3a shows a perspective view of the rectangular top plate 14a of the housing 14. Fig. 3b shows a corresponding perspective view of the remaining parts of the housing, including the four lateral housing walls 14c to 14f and the bottom plate 14b. In the embodiment shown, the top plate 14a is dimensioned such as to fit to an outer perimeter defined by the upper edge of the four lateral housing walls 14c-14f. The top plate 14a can hence be engaged with the four lateral housing walls 14c-14f, thereby forming a pressure snap connection between the top plate 14a and the lateral housing walls 14c-14f. The top plate 14a hence works as a removable cover of the housing 14. The top plate 14a comprises a sealing element 11, which in the embodiment shown is a sealing rubber band extending around an external perimeter of the top plate 14a on an internal surface thereof, i.e. on a surface facing the interior of the housing 14 when the top plate 14a is attached to the remaining part of the housing 14. Thus, when the top plate 14a is attached to the rest of the housing 14, the interior of the housing is sealed.

Fig. 3b illustrates a perspective view of the remaining part of the housing 14, i.e. of parts of the housing apart from the top plate 14a. Figs. 3c and 3d respectively illustrate a top view (in which the top plate 14a is omitted for illustrative purposes) and a bottom view of the housing 14 of Fig. 3a.

In the embodiment shown in Fig. 3, the housing comprises the first internal compartment previously described for the embodiment illustrated in Fig. 2 and further comprises a second internal compartment 30, a third internal compartment 40 and a fourth internal compartment 50. The first internal compartment 20, the third internal compartment 40 and the fourth internal compartment 50 are all arranged adjacent to the second lateral housing wall 14d and adjacent to the second internal compartment 30. An internal wall formed by the first lateral compartment wall 20a, a first lateral compartment wall 40a of the third internal compartment 40 and a first lateral compartment wall 50a of the fourth internal compartment 50 separates the second internal compartment 30 from each of the first internal compartment 20, the third internal compartment 40 and the fourth internal compartment 50.

The interior of the housing 14 is hence divided in the first to fourth internal compartments 20, 30, 40 and 50. The third internal compartment 40 is arranged between the first internal compartment 20 and the fourth internal compartment 50, such that the first and fourth internal compartments 20 and 50 are mutually separated by the third internal compartment 40. The second internal compartment 30 is arranged adjacent to the first lateral housing wall 14f and is limited by the fourth lateral housing wall 14f, by an internal lateral wall formed by the first lateral compartment walls 20a, 40a and 50a of the first, third and fourth internal compartments 20, 40 and 50, which extends from the first lateral housing wall 14c to the third lateral housing wall 14e, and by corresponding parts of the first and third lateral housing walls 14c and 14e, as seen in Fig. 3b. The first internal compartment 20 is separated from the first internal compartment 40 by the second lateral compartment wall 20b of the first internal compartment 20. The fourth internal compartment 50 is separated from the third internal compartment 40 by a second lateral compartment wall 50b of the fourth internal compartment 50. All lateral compartment walls can be similar in construction to the first and second compartment walls 20a and 20b described above for the embodiment illustrated in Fig. 2.

As seen in figs. 3b and 3d, the housing 14 further comprises, in the embodiment shown, a plurality of heat dissipation fins 18 arranged on an outer surface of the bottom plate 14b of the housing 14. Although three heat dissipation fins 18 are exemplary shown in Fig. 3, the power converting system can comprise any larger number of heat dissipation fins 18.

All parts of the housing 14 illustrated in figures 3b to 3d, including the four lateral housing walls 14c-14f, the bottom plate 14b and the lateral compartment walls 20a, 20b, 40a, 50a and 50b, as well as the heat dissipation fins 18, form a monolithic part of the housing that can be formed in a single manufacturing step, for example by using the same mould in a moulding process.

Also shown in Fig. 3 are a first resealable opening 19a formed in the top plate 14a (cf. Fig. 3a) and a second resealable opening 19b formed in the bottom plate 14b (cf. Fig. 3c).

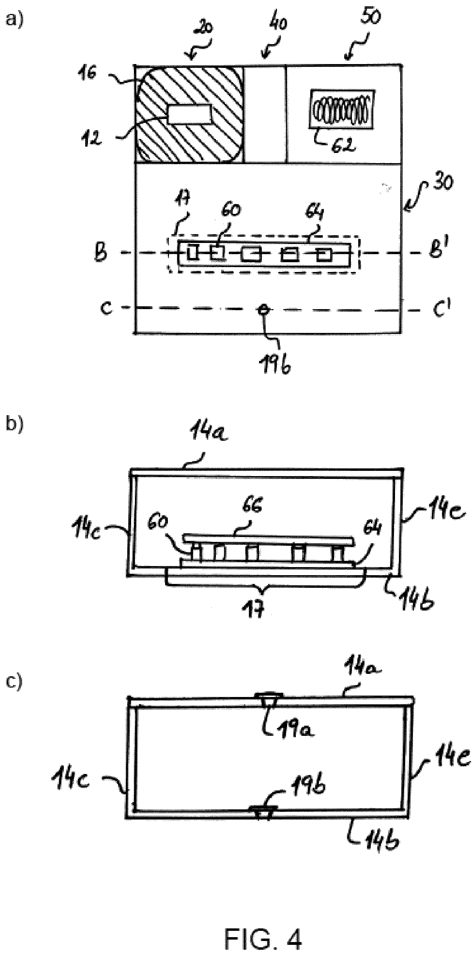

Fig. 4 illustrates a power converting system 10 according to embodiments of the invention that comprises the housing described with respect to the embodiment illustrated in Fig. 3, the different parts of which are indicated with the same reference numerals and shall not be described in detail again for brevity. The power converting system illustrated in Fig. 4 further comprises the components of a power converting system previously described for the embodiments illustrated in figs. 1 and 2. Fig. 4a is a schematic top view of the power converting system 10 in which the top plate 14a is omitted for illustrative purposes. In the embodiment shown in Fig. 4, the power converter device 12 is received within the first internal compartment 20. The thermally conductive filler 16 encloses the power converter device 12 completely and fills a major part of the space between the power converter device 12 and the internal surface of the first internal compartment 20, i.e. a majority of the volume of the interior of the first internal compartment 20. The thermally conductive filler is in contact with all sides of the power converter device 12 and with all sides of the interior surface of the first internal compartment 20.

A portion 17 of the internal surface of the bottom plate 14b comprised within the second internal compartment 30 is polished. The polished portion 17 can be polished as a result of a mechanical polishing process. The power converting system 10 of the embodiment illustrated in Fig. 4 further comprises a dielectric sheet 64 of mica arranged on the polished portion 17 of the internal surface of the bottom plate 14b. A plurality of MOSFETs are directly arranged on the dielectric sheet 64, within the second internal compartment 30. As shown in Fig. 4b, the MOSFETs 60 are attached to the polished portion 17 of the internal surface of the bottom plate 14b via the dielectric sheet 64. A PCB 66 is arranged on the MOSFETs 60. The PCB 66 comprises electronic circuitry for controlling the main functionalities required for the operation of the power converting system 10, such as connectivity to other devices or a charging program, including charging parameters such as electric current, electric voltage, and electric power.

The power converting system 10 further comprises an auxiliary coil 62 comprised in the fourth internal compartment 50. The auxiliary coil 62 is arranged on the bottom plate 14b. In the embodiment shown, the auxiliary coil 62 operates as a power factor correction coil. Fig. 4b illustrates a cross-sectional side view of the power converting system 10 of Fig. 4a corresponding to a cutting-plane B-B' that is indicated in Fig. 4a as a dashed line. Fig. 4c illustrates a further cross-section side view corresponding to a second cutting-plane C-C'.

The internal compartment 40 is arranged between the first internal compartment 20 and the fourth internal compartment 50, such that the first internal compartment is separated from the fourth internal compartment 50 by the third internal compartment 40. The third internal compartment 40 is filled with air and hence forms a air chambers that thermally isolates the first internal compartment from the fourth internal compartment.

As seen in Fig. 4c, the removable top plate 14a and the bottom plate 14b respectively comprise a first resealable opening 19a and a second resealable opening 19b. The first and second resealable openings 19a and 19b comprise a pressure sensitive movable closing element, such as a mechanical pressure valve or a movable membrane, which can react to pressure gradients in the interior of the housing 14. When heat concentrates in an upper part of the interior of the housing 14, a pressure gradient between the upper part - proximal to the top plate 14a - and the lower part - proximal to the bottom plate 14b - of the housing, causes the movable closing elements of the sealable openings 19a, 19b to open, such that air from the exterior of the housing 14 can flow into the interior of the housing 14, for example entering through the second opening 19b, and back to the exterior of the housing 14, for example through the second opening 19a, thereby cooling down the interior of the housing 14. The resealable openings 19a and 19b can be configured to open when the aforesaid pressure gradient reaches or exceeds a predefined pressure gradient threshold. As long as this pressure gradient threshold is not reached or exceeded, the resealable openings 19a and 19b remain closed, such that the interior of the housing 14 is sealed.

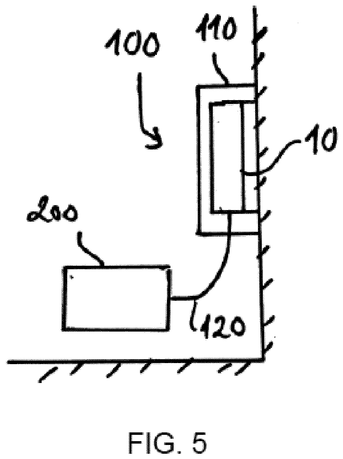

Fig. 5 schematically illustrates a battery charger 100, which comprises a power converting system 10 and a protective case 110. The power converting system 10, which may be a power converting system according to any of the previously discussed embodiments, is attached to a wall, which may for example be a building wall or a wall of a stable element such as a charging column, and is enclosed by the protective case 110. The power converting system 10 operates as an AC-DC converter. The battery charger 100 is configured for charging a power battery 200, which may for example correspond to the battery of an electric car. The battery charger 100 is electrically connected to the battery 200 by means of a charger cable 120.

### LIST OF REFERENCE SIGNS

- 10: power converting system
- 12: power converter device
- 14: housing
- 14a: top plate
- 14b: bottom plate
- 14c-14f: lateral housing walls
- 15: attaching means
- 16: thermally conductive filler
- 17: polished portion of housing surface
- 18: heat dissipation fins
- 19a, 19b: resealable openings
- 20: first internal compartment
- 20a, 20b: internal compartment walls
- 30: second internal compartment
- 40: third internal compartment
- 40a: internal compartment wall
- 50: fourth internal compartment
- 50a: internal compartment wall
- 60, 62: electronic components
- 64: dielectric sheet
- 66: PCB
- 100: battery charger
- 110: protective case
- 200: battery

## Claims

1. A power converting system (10) comprising:
a power converter device (12),
a thermally conductive filler (16), and
a housing (14), wherein the housing encloses the power converter device (12) and the thermally conductive filler (16),
wherein the thermally conductive filler (16) surrounds the power converter device (12) and fills at least in part a space between the power converter device (12) and at least a part of an internal surface of the housing (14).

2. The power converting system of claim 1, wherein the filler (16) encloses the power converter device (12) completely

3. The power converting system of claim 1 or 2, wherein the filler (16) is in direct contact with the power converter device (12) and/or with the at least a part of the internal surface of the housing (14).

4. The power converting system of any of the preceding claims, wherein the thermally conductive filler (16) comprises a polyurethane resin, an epoxy resin, a thermosetting plastic, a silicone rubber gel or a combination thereof.

5. The power converting system of any of the preceding claims, wherein the housing (14) comprises a first internal compartment (20), wherein the power converter device (12) is received within the first internal compartment (20), and wherein the filler (16) further fills at least in part a space between the power converter device (12) and at least a part of an internal surface of the first internal compartment (20).

6. The power converting system of claim 5, wherein the first internal compartment (20) is limited by one or more lateral compartment walls (20a, 20b) and a part of the internal surface of the housing (14); and/or
wherein a part of an internal surface of the first internal compartment (20) coincides with a part of an internal surface of the housing (14).

7. The power converting system of any of the preceding claims, wherein the housing (14) comprises a top plate (14a), a bottom plate (14b) and at least a lateral housing wall (14c-14f) extending between the bottom plate (14b) and the top plate (14a), wherein the bottom plate (14b) and/or the top plate (14a) preferably is removably attachable to the rest of the housing (14).

8. The power converting system of claims 6 and 7, wherein the one or more lateral compartment walls (20a, 20b) extend from the top plate (14a) to the bottom plate (14b).

9. The power converting system of any of the preceding claims, wherein the housing (14) is monolithic or wherein the housing (14) comprises a monolithic part of the housing (14) comprising at least the bottom plate (14b) or the top plate (14a) and further comprising the one or more lateral walls (14c-14e); and/or
wherein the power converting system further comprises one or more heat dissipation fins (18) arranged on an outer surface of the housing (14), wherein a monolithic part of the housing (14) preferably further comprises the one or more heat dissipation fins (18).

10. The power converting system of any of the preceding claims, wherein the housing (14) is formed of or comprises a thermally conductive material, preferably a metal or an alloy, more preferably aluminum or an alloy thereof.

11. The power converting system of any of the preceding claims, wherein the power converter device (12) is configured for operating in the high frequency range, preferably in the range from 100 kHz to 2 MHz, more preferably in the range from 250 kHz to 500 kHz or from 250 kHz to 750 kHz.

12. The power converting system of any of the preceding claims, further comprising electronic components (60, 62), preferably MOSFETS, arranged on an internal surface of the housing (14), preferably further comprising a dielectric sheet (64) directly arranged on the internal surface of the housing (14), wherein the electronic components (60) are arranged on the dielectric sheet (64); and/or
wherein the housing (14) comprises a second internal compartment (30), wherein the electronic components (60) are arranged in the second internal compartment (30); and/or
wherein at least a portion (17) of an internal surface of the housing (14) is polished, wherein the electronic components (60) are preferably arranged over said at least a portion (17).

13. The power converting system of any of the preceding claims, wherein the housing (14) further comprises at least two resealable openings (19a, 19b) respectively arranged on opposed surfaces of the housing (14).

14. The power converting system of any of the preceding claims, further comprising a third internal compartment (40) filled with a fluid, preferably a gas, more preferably air wherein the third internal compartment (40) is preferably adjacent to the first internal compartment (20) and/or to the second internal compartment (30),
wherein the power converting system preferably further comprises a fourth internal compartment (50) adjacent to the second internal compartment (30) and to the third internal compartment (40), wherein the third internal compartment (40) is preferably arranged between the first internal compartment (20) and the fourth internal compartment (50).

15. A battery charger (100) for charging power batteries comprising a power converting system (10) according to any of the preceding claims.
